# EUROPÄISCHE PATENTSCHRIFT

(11) **EP 1 481 110 B1**
(45) Veröffentlichungstag und Bekanntmachung des Hinweises auf die Patenterteilung: **07.12.2005**
(21) Anmeldenummer: 03714759.2
(22) Anmeldetag: 27.02.2003
(51) Int. Cl.: C23C 14/00, C23C 14/16, C23C 14/34, C23C 14/56, C23C 16/44, B01J 3/00

(54) **BESCHICHTUNG AUS EINER GETTERMETALL-LEGIERUNG SOWIE ANORDNUNG UND VERFAHREN ZUR HERSTELLUNG DERSELBEN**
GETTER METAL ALLOY COATING AND DEVICE AND METHOD FOR THE PRODUCTION THEREOF
REVETEMENT A BASE D'ALLIAGE DE METAL GETTER, ET SYSTEME ET PROCEDE PERMETTANT DE LE PRODUIRE

(30) Priorität: 05.03.2002 DE 10209423
(43) Veröffentlichungstag der Anmeldung: 01.12.2004
(73) Patentinhaber: Gesellschaft für Schwerionenforschung mbH, 64291 Darmstadt (DE)
(72) Erfinder: REICH-SPRENGER, Hartmut, 64347 Griesheim (DE)
(74) Vertreter: Boeters, Hans Dietrich
(86) Internationale Anmeldenummer: PCT/EP2003/002031
(87) Internationale Veröffentlichungsnummer: WO 2003/074753

(56) Entgegenhaltungen:
- EP-A- 0 926 258
- WO-A-00/61832
- WO-A-97/17542
- WO-A-97/49109
- WO-A-98/37958

## Beschreibung

Die Erfindung betrifft eine Beschichtung aus einer Gettermetall-Legierung und eine Vorrichtung und ein Verfahren zur Herstellung derselben gemäß der Gattung der unabhängigen Ansprüche.

Gettermetalle, die Substanzen umfassen, die dazu dienen, letzte Spuren von störenden oder schädlichen Gasen aus Hochvakuumräumen durch Sorption oder direkte chemische Reaktion zu binden, können in zwei Gruppen eingeteilt werden. Die eine Gruppe bilden die verdampfbaren Gettermetalle, die in einem Röhrenkolben beim ersten Hochheizen der Röhre verdampft werden und dabei letzte Spuren von störenden oder schädlichen Gasen aus dem Hochvakuumraum durch Sorption oder durch direkte chemische Reaktion binden. Zu diesen gehören die bei niedriger Temperatur verdampfenden Gettermetalle Cäsium mit 678°C Verdampfungstemperatur, Natrium mit 882 °C Verdampfungstemperatur, Magnesium mit 1.090 °C Verdampfungstemperatur, Calcium mit 1.484 °C Verdampfungstemperatur und Barium mit 1.640 °C Verdampfungstemperatur. Die andere Gruppe der Gettermetalle besteht aus Metallen, die nicht zur Entfaltung ihrer Wirkung verdampft werden müssen, sondern die bei Temperaturen über 3.000 °C erst verdampfen, aber eine Getterwirkung teilweise schon bei Aktivierungstemperaturen ab 120 °C aufweisen. Zu dieser Gruppe nicht-verdampfbarer Gettermetalle zählen die Metalle Titan mit einer Verdampfungstemperatur von 3.287 °C, Zirkonium mit einer Verdampfungstemperatur von 4.377 °C und Hafnium mit einer Verdampfungstemperatur von 4.602 °C.

Beschichtungen aus derartigen nicht-verdampfenden Gettermetallen werden für Getterpumpen eingesetzt, bei denen das nichtverdampfende Gettermetall im Vakuum erhitzt wird, so daß bei einer für eine bestimmte Gettermetall-Legierung typischen Aktivierungstemperatur die an der Oberfläche zunächst gebundenen chemischen reaktiven Gase in den Festkörper des Gettermetalles eindiffundieren. Nach dem Abkühlen des Gettermetalls beispielsweise auf Raumtemperatur können an dessen reaktiver Oberfläche wieder reaktive Restgaskomponenten wie Sauerstoffmoleküle oder Wassermoleküle gebunden werden.

Die Wirkung der Gettermetall-Legierung kann jedoch durch den Einschluß von Edelgasen beeinträchtigt werden, mit denen die Getterlegierungen bei der Herstellung von Getterpumpenoberflächen belastet werden. Diese Belastung durch Edelgase wie Argon oder Krypton kann die Aufnahmefähigkeit vermindern, das heißt, das Sorptionsvermögen der Getterpumpenoberfläche, da ein Anteil der Aktivierungspositionen an der Oberfläche und im Inneren der Getterpumpenmetalle durch Edelgaseinschlüsse abgeschirmt oder belastet sind. Des weiteren besteht die Gefahr des "Wiederausgasens", das heißt, daß eingeschlossene Edelgasmoleküle aus dem Gettermaterial wieder diffundieren und das UHV verschlechtern.

Ein wesentliches technisches Problem besteht auch bei der Herstellung von Getterpumpen. Aufgrund des hohen Schmelzpunktes der nicht-verdampfenden Gettermetall-Legierungen ist ein Aufschmelzen und Aufdampfen der Getterlegierungen auf die Oberflächen einer Getterpumpe, wie es sonst bei verdampfbaren Gettermetall-Legierungen vorgenommen wird, nicht möglich. Deshalb hat sich eine Technik durchgesetzt, bei der ein Feinvakuumbereich mit einem Restgasdruck von etwa 2 Pa eines Edelgases wie Argon oder Krypton eingestellt wird und dieses Restgas einer Gasentladung ausgesetzt wird. Dabei wird eine auf negativem Potential liegende Opferkathode von den positiv geladenen Gasionen in einem Sputterprozeß zerstäubt. Bei diesem Sputterprozeß wird nicht nur die Opferkathode aus Gettermetall zerstäubt, sondern es wird auch ein Anteil des Sputtergases wie Argon oder Krypton in der Getterpumpenbeschichtung eingelagert. Hinzu kommt ein weiterer Nachteil dieses Verfahrens, daß aufgrund der geringen Zerstäubungsrate der hochschmelzenden Gettermetalle im Sputterprozeß der Aufbau der Schicht einer Getterpumpe äußerst langwierig ist. Somit können in vertretbarer Zeit nur dünne Getterschichten oder Schichtdicken aufgebracht werden, was wiederum die Getterpumpwirkung zeitlich begrenzt, da die Aufnahmekapazität des Volumens der Beschichtung aufgrund der minimalen Dicke äußerst begrenzt ist.

Aufgabe der Erfindung ist es, die Nachteile im Stand der Technik zu überwinden und eine Beschichtung aus einer nicht-verdampfenden Gettermetall-Legierung für eine Innenwand eines Ultrahochvakuum-Behälters zu schaffen, die einerseits eine hohe Aufnahmekapazität für Restgase aufweist und zusätzlich eine hohe Anzahl an Pumpzyklen zuläßt, bevor das Volumen mit reaktiven Restgasen aufgefüllt ist.

Gelöst wird diese Aufgabe mit dem Gegenstand der unabhängigen Ansprüche. Merkmale weiterer vorteilhafter Ausführungsformen der Erfindung ergeben sich aus den abhängigen Ansprüchen.

Erfindungsgemäß wird eine Beschichtung aus einer nicht-verdampfenden Gettermetall-Legierung für eine Innenwand eines U1-trahochvakuum-Behälters vorgeschlagen, wobei die Gettermetall-Legierung mindestens ein Gettermetall mit einer Schmelztemperatur über 1.500 °C und einer Verdampfungstemperatur über 3.000 °C aufweist. Dabei ist die Gettermetall-Legierungsbeschichtung von Edelgaseinschlüssen unbelastet und weist ein Metall-Legierungsabscheidungsprodukt eines edelgasfreien Gettermetall-Legierungsplasmas auf. Diese Beschichtung hat den Vorteil, daß sie kein Edelgassputterprodukt ist, sondern ein Metall-Legierungsabscheidungsprodukt darstellt, das aus einem edelgasfreien Gettermetall-Legierungsplasma hervorgegangen ist. Derartige Gettermetall-Legierungsschichten können wesentlich dicker in wesentlich kürzeren Prozeßzeiten realisiert werden, so daß eine hohe Aufnahmekapazität an reaktiven Restgasen ein wesentlicher Vorteil der erfindungsgemäßen Gettermetall-Beschichtung ist. Darüber hinaus wird die Aufnahmekapazität für reaktive Gase noch gesteigert, weil keinerlei Einschlüsse von Edelgasmetallen die Aufnahmekapazität mindern.

In einer bevorzugten Ausführungsform der Erfindung weist die Gettermetall-Legierung Titan, Zirkonium und/oder Vanadium auf. Dabei gehört Vanadium nicht unmittelbar zu den nicht-verdampfenden Gettermetallen und ist hier vielmehr als Bindemetall für die getternd wirkenden Anteile aus Titan und Zirkonium eingesetzt.

Eine weitere bevorzugte Ausführungsform der Erfindung sieht vor, daß die Gettermetall-Legierung Titan, Zirkonium und/oder Hafnium aufweist. In dieser Zusammensetzung ergibt sich eine Getterlegierung, die durch das Titan zusammengehalten wird, wobei alle drei Komponenten Getterwirkungen und entsprechend hohe Aktivierungstemperaturen aufweisen. Eine weitere Getterlegierung ist dadurch gekennzeichnet, daß sie Vanadium, Zirkonium und Hafnium aufweist. Auch hier ist das Vanadium kein Metall, das unmittelbar Getterwirkung entfaltet, jedoch hilft es, die Zirkonium und Hafniumbestandteile in ihrer Getterwirkung zu stimulieren und miteinander homogen zu vermischen.

Für eine weitere bevorzugte Ausführungsform der Erfindung ist es vorgesehen, daß die Gettermetall-Legierung eine Aktivierungstemperatur zwischen 120 und 500 °C aufweist. Dieser Aktivierungstemperaturbereich zwischen 120 und 500 °C ist durch die Variation der Anteile der beteiligten Gettermetall-Legierungen darstellbar. Ein bevorzugter Ausschnitt aus diesem Bereich weist Gettermetall-Legierungen auf, die eine Aktivierungstemperatur unter 200 °C und über 120 °C aufweisen. Derartige Aktivierungstemperaturen entsprechen den Ausheiztemperaturen beim normalen Hochvakuumbetrieb, so daß die getternde Beschichtung und der Ausheizvorgang zur Herstellung von Ultrahochvakuum miteinander kombiniert werden können.

Eine weitere vorteilhafte Weiterbildung der Erfindung sieht vor, daß die Gettermetall-Legierung eine Aktivierungstemperatur über 250 und bis zu 500 °C aufweist. In diesem Fall eignet sich besonders die Kombination aus Titan, Zirkonium und Hafnium als Gettermetall-Legierung, zumal mit Hafnium ein Gettermetall mit der höchsten Schmelztemperatur und der höchsten Verdampfungstemperatur in die Beschichtung aufgenommen wird. Dieser deutlich über der Standardausheiztemperatur liegende Bereich hat den Vorteil, daß getrennt bei niedrigeren Temperaturen zwischen 100 und 150 °C das Ausheizen in mehreren Stufen durchgeführt werden kann und erst bei vollständiger Trockenheit der Restatmosphäre in dem Hochvakuumbehälter nun bei deutlich über der Ausheiztemperatur liegenden Temperaturen zwischen 250 und 500 °C ein Reaktivieren der Oberfläche der Gettermaterialien stattfindet. Wird dieser Reaktivierungszyklus mehrfach wiederholt, indem nach dem Abkühlen erneut eine derart hohe Aktivierungstemperatur eingestellt wird, kann ein Ultrahochvakuum in einem Hochvakuumbehälter mehrfach reproduziert werden.

Um die Herstellung einer Gettermetall-Legierungsbeschichtung auf einer Innenwand eines zu beschichtenden Hochvakuumbehälters durchzuführen, wird erfindungsgemäß folgende Anordnung vorgesehen: die Anordnung weist im wesentlichen einen Metallplasmagenerator auf, der wiederum folgende Komponenten aufweist:
- einen Isolationskörper mit einer Zündelektrode und einem Kathodendraht aus einer Gettermetall-Legierung, wobei Zündelektrode und Kathodendraht mit einem Zündimpulsgenerator bzw. mit einem Kathodenpotential verbindbar sind und die Zündelektrode sowie der Kathodendraht an dem Isolationskörper räumlich getrennt voneinander angeordnet sind;
- einen käfigförmigen Anodenkörper, der den Isolationskörper in einem räumlichen Abstand umgibt und mit einem Anodenpotential verbindbar ist, wobei Isolationskörper und umgebender Anodenkörper in den Innenraum des zu beschichtenden Hochvakuumbehälters beim Beschichten hineinragen; und
- eine Spannungsversorgungsvorrichtung mit Kathodenpotentialeinrichtung für ein Anlegen des Kathodenpotentials über eine Vakuumdurchführung an den Kathodendraht und zum Anlegen eines Hochspannungszündimpulses über eine Vakuumhochspannungsdurchführung an die Zündelektrode sowie zum Anschluß des Anodenpotentials an den zu beschichtenden Hochvakuumbehälter und den Anodenkörper.

Mit dieser relativ einfachen Anordnung ist es möglich, den Kathodendraht nach der Zündung in ein Plasma umzusetzen, das sich in Richtung des Anodenkäfigs ausbreitet und durch die Öffnungen des Kathodenkäfigs hindurch ein Metallplasma auf die Innenwandung des Hochvakuumbehälters sprüht, zumal der Hochvakuumbehälter auf dem gleichen Anodenpotential liegt wie die käfigförmige Anodenkörper. Die Zündelektrode verursacht beim Anlegen eines Zündimpulses von mehr als 10 kV ein Metallplasma, das sich über den Isolationskörper ausbreitet und die Kathoden-Anoden-Strecke zündet, so daß das Kathodenmaterial nacheinander in ein Metallplasma umgesetzt wird und auf die Innenwandung des Hochvakuumbehälters gesprüht wird.

Somit hängt die Dicke der aufgesprühten Gettermetall-Beschichtung auf der Innenwand des Hochvakuumbehälters von der Dicke des Kathodendrahtes ab, der als Gettermetall-Legierung in ein Gettermetallplasma umgesetzt wird. Dieser auch als Lichtbogen bekannte Effekt setzt pro Sekunde wesentlich mehr Metallplasma frei, als es ein Sputterprozeß in einer Stunde vermag. Insofern lassen sich äußerst dicke Gettermetall-Legierungsschichten herstellen, die eine entsprechend hohe Aufnahmefähigkeit von reaktiven Gasen aufweisen.

Prinzipiell kann eine Anordnung mit einem Metallplasmagenerator in zwei Versionen ausgeführt werden, in einer ersten Version wird der Metallplasmagenerator als ein Metallplasmasprühkopf ausgebildet, und in einem zweiten grundlegenden Fall wird der Plasmagenerator als ein Metallplasmasprühstab ausgebildet. Somit weist im ersten Fall die Anordnung zunächst einen Metallplasmasprühkopf auf, der den Isolationskörper mit Kathodendraht und Zündelektrode und den umgebenden Anodenkörper umfaßt und in dem Innenraum des zu beschichtenden Hochvakuumbehälters unter Hochvakuum verfahrbar angeordnet ist.

Ein derartiger Metallplasmasprühkopf hat den Vorteil, daß er mit unterschiedlichen Geschwindigkeiten in einzelnen Sektionen eines Vakuumbehälters verfahrbar ist und damit die Dicke der Gettermetall-Beschichtung variabel, beispielsweise in Achsrichtung, herstellbar wird. In einer bevorzugten Ausführungsform der Erfindung weist die Anordnung dafür eine Hochvakuumschiebedurchführung auf, die eine Linearverschiebung des Metallplasmasprühkopfes innerhalb des Innenraumes des zu beschichtenden Hochvakuumbehälters ermöglicht. Diese Anordnung hat den Vorteil, daß sie an beliebig lange Hochvakuumrohrstükke anflanschbar ist und in Abhängigkeit von der Länge des zu beschichtenden Hochvakuumrohres die Hochvakuumschiebedurchführung auszuführen ist.

Eine weitere bevorzugte Ausführungsform der Erfindung sieht vor, daß die Anordnung einen Metallplasmasprühstab aufweist, der einen Isolationsstab als Isolationskörper mit Zündelektrode und auf seinem Mantel einen aufgewickelten Kathodendraht sowie den umgebenden Anodenkörper umfaßt und in dem Innenraum des zu beschichtenden Hochvakuumbehälters angeordnet ist. Ein derartiger Metallplasmasprühstab hat den Vorteil, daß lediglich ein Flansch erforderlich ist, der den Hochvakuumsprühstab trägt und an ein zu beschichtendes Hochvakuumrohr oder an einen zu beschichtenden Hochvakuumbehälter anzuflanschen ist. Etwaige Hochvakuumschiebedurchführungen können bei diesem Metallplasmasprühstab entfallen.

Im Prinzip weist der Isolationskörper des Metallplasmasprühstabes in seinem Zentrum eine Zündzuleitung auf, die bis zur Stirnfläche des Isolationsstabes reicht und dort in einer Zündelektrode endet. Diese Zündelektrode kann scheibenförmig oder als Ringplatte ausgeführt sein, wobei zum Zünden des Gettermetallplasmas zunächst ein Zündimpuls über die Zufuhrleitung an die Zündelektrode gelegt wird und an der Stirnseite ein Zündplasma zwischen zündelektrode und Kathodendraht auftritt, das sich zur Anode hin fortplanzt und weiter bestehen bleibt, wenn zwischenzeitlich der aufgewickelte Kathodenstrahl auf ein Kathodenpotential gelegt worden ist und der Anodenkörper zusammen mit der Hochvakuumbehälterwandung auf ein Massepotential gelegt wurde.

Der Kathodendraht kann mehrere Windungen parallel auf dem Isolationskörper aufweisen. Entsprechend viele Metallplasmafäden erstrecken sich dann über die Anode zu der Innenwand des Hochvakuumbehälters. Beispielsweise bei einer Anordnung von vier Kathodendrähten auf dem Umfang des Isolationsstabes verteilt, entstehen vier umlaufende Gettermetallplasmastrecken, die so lange aufrechterhalten bleiben, wie entweder das Kathodenpotential anliegt oder solange ein Kathodendraht noch vorhanden ist. Dabei muß gesichert werden, daß der Kathodendraht von der Stirnseite her fortlaufend zum Ende des Isolationsstabes hin einen Metallplasmastrahl in Richtung auf die käfigförmige Anode und von dort auf die Innenwand des Hochvakuumbehälters richtet.

Um sicherzustellen, daß das Metallplasma beim Metallplasmasprühstab im Bereich der Stirnseite beginnt, und sich dann zum Ende des Isolationsstabs hin fortsetzt, weist in einer bevorzugten Ausführungsform der Erfindung der Isolationsstab in axialer Richtung einen Konus auf, dessen Radius in axialer Richtung zu der Stirnseite des Isolationsstabes hin zunimmt. Somit ist der geringste Abstand zwischen dem Anodenkörper in Form eines Anodenkäfigs und dem Kathodendraht an der Stirnseite gewährleistet, und ein Lichtbogen aus einer Gettermetall-Legierung wird sich umlaufend um den Isolationsstab in Richtung auf die Vakuumdurchführung des Kathodendrahtes ausbreiten und die Innenwand des Hochvakuumbehälters gleichmäßig beschichten. Der Konuswinkel des konusförmigen Isolationsstabes kann zwischen 1° und 15° aufweisen. Ein derart flacher Winkel reicht aus, um sicherzustellen, daß sich das Gettermetall-Legierungsplasma von der Stirnseite beginnend und dem Metallplasmasprühstab folgend ausbreitet.

Die käfigförmige Anode, die in einem räumlichen Abstand den Kathodendraht umgibt, könnte aufgrund der Käfigstruktur eine entsprechend strukturierte Innenwandbeschichtung auf der Innenwand des Hochvakuumbehälters verursachen. Um eine derartige strukturierte Beschichtung zu vermeiden, kann vorgesehen werden, daß die Anordnung eine Drehdurchführung für den Metallplasmasprühstab und/oder den Metallplasmasprühkopf aufweist, so daß unter ständigem Drehen des Metallplasmasprühstabes bzw. des Plasmasprühkopfes mit der Anode eine gleichmäßige Dicke auf der Innenwand des Hochvakuumbehälters für die Gettermetall-Beschichtung erreicht wird.

Zur Stabilisierung der Positionierung sowohl des Metallplasmasprühstabes als auch des Metallplasmasprühkopfes können diese von einem Stützflansch getragen werden, der an den zu beschichtenden Hochvakuumbehälter vakuumdicht anflanschbar ist. Ein derartiger Stützflansch hat den Vorteil, daß diese Vorrichtung relativ leicht an jeden beliebigen Hochvakuumbehälter anflanschbar ist, solange dieser eine ausreichend große Öffnung aufweist, die durch den Stützflansch vakuumdicht abgedichtet werden kann.

Der käfigförmige Anodenkörper kann aus einem Drahtgitter gebildet sein. Bei einer derartigen bevorzugten Ausführungsform werden die Drahtgitterstäbe an ihren Kreuzungspunkten vorzugsweise aufeinander geschweißt, um einerseits eine hohe Stabilität für den Anodenkäfig zu erreichen und andererseits eine gleichmäßige Potentialverteilung trotz Metallplasmastromes zu gewährleisten. Eine weitere bevorzugte Ausführungsform der Erfindung sieht vor, daß der käfigförmige Anodenkörper aus einem Lochblech gebildet wird. Ein Lochblech hat gegenüber einem Drahtgeflecht als Anodenkörper eine noch höhere Stabilität. Das Material des Anodenkörpers weist eine hochschmelzende Metall-Legierung mit einer Schmelztemperatur über 1.500 °C und mit einer Verdampfungstemperatur über 3.000 °C auf. Dieses soll gewährleisten, daß das heiße Metallplasma kein Material des Anodenkörpers in die Gettermetall-Beschichtung einbringt.

In einer weiteren bevorzugten Ausführungsform der Erfindung besteht der Anodenkörper aus einer Gettermetall-Legierung, die eine höhere Verdampfungstemperatur aufweist als die Gettermetall-legierung des Kathodendrahtes. Dieses hat den Vorteil, daß bei einem Kontaminieren der Gettermetall-Beschichtung mit dem Anodenkörpermaterial ebenfalls nur eine Gettermetall-Legierung eingebaut wird, welche die Gettermetallwirkung der Beschichtung unterstützt und nicht wie im Stand der Technik die Aktivität der Gettermetall-Beschichtung durch Edelgasionen behindert. Als besonders geeignetes Material kann hier Hafnium eingesetzt werden, das die höchste Schmelztemperatur und die höchste Verdampfungstemperatur der Gettermetalle aufweist.

In einer weiteren bevorzugten Ausführungsform der Erfindung ist die Zündelektrode an der in den Hochspannungsbehälter hineinragenden Stirnseite des Isolationskörpers angeordnet. Diese Position der Zündelektrode gewährleistet einen Start des Metallplasmas im Bereich der Stirnseite des Isolationskörpers und hat den Vorteil, daß die Zündelektrode relativ einfach gestaltet werden kann. Dazu weist der Isolationskörper ein zylindrisches Keramikrohr auf, das in seinem Achsbereich einen Zuführungsdraht zu einer zentralen Metallplatte als Zündelektrode auf der Stirnseite des Isolationskörpers aufweist. Somit ergibt sich eine relativ einfache Montage und Fixierung der Zündelektrode im Zentrum der Stirnseite eines Gettermetallplasmasprühstabes.

Bei einem Gettermetallplasmasprühkopf wird in einer bevorzugten Ausführungsform der Erfindung der Isolationskörper als ein Keramikring gestaltet. Die Ringöffnung dieses Keramikringes trägt ein Bündel aus Kathodendrähten, während die Zündelektrode auf dem Keramikring als Metallring aufgebracht ist. Der Metallring, der hier als Zündelektrode auf dem Keramikring als Isolationskörper angeordnet ist, weist eine entsprechende Zündzuleitung auf, die mit der Spannungsversorgungsvorrichtung in Wirkverbindung steht.

Zum zünden wird ein Zündimpuls über die Zündzuleitung auf den Metallring gegeben, so daß sich von dem Bündel der Kathodendrähte in der Ringöffnung des Keramikringes, die auf Kathodenpotential liegen, ein Metallplasma radial ausbreitet, das sich zur räumlich umgebenden käfigförmigen Anode hin erstreckt und durch diese hindurch die auf Anodenpotential liegende Innenwandung des Vakuumbehälters beschichtet. Zwar wird die Zündelektrode nur für die Länge eines oder mehrerer Zündimpulse mit einer Hochspannung von mehreren 10 kV beaufschlagt, jedoch kann auch dieses zum Kontaminieren der Gettermetall-Legierung mit Zündelektrodenmaterial beitragen. Deshalb wird in einer vorteilhaften Weiterbildung der Erfindung eine hochschmelzende Metall-Legierung mit einer Schmelztemperatur über 1.500 °C und einer Verdampfungstemperatur über 3.000 °C für die Zündelektrode vorgesehen.

Für besonders stabile und für eine hochreine Gettermetall-Beschichtung vorgesehene Zündelektroden wird eine Gettermetall-Legierung eingesetzt, die eine höhere Verdampfungstemperatur aufweist als die Gettermetaqll-Legierung des Kathodendrahtes. In diesem Fall kann durch die Kontamination von Gettermetall der Zündelektrode die Qualität der Gettermetall-Beschichtung eher verbessert als verschlechtert werden.

Eine besondere Anwendung für eine derartige Gettermetall-Beschichtung besteht darin, daß der zu beschichtende Hochvakuumbehälter ein Strahlführungsrohr einer Ionenstrahlbeschleunigungsanlage ist.

Ein Verfahren zur Herstellung einer Beschichtung aus einer nicht-verdampfenden Gettermetall-Legierung auf einer Innenwand eines zu beschichtenden Hochvakuumbehälters weist folgende Verfahrensschritte auf:

Zunächst wird mittels mindestens eines Hochspannungszündimpulses ein Plasmalichtbogen zwischen einem Kathodendraht aus einer Gettermetall-Legierung und einem Anodenkörper gezündet. Danach wird unter fortlaufender Umwandlung des Kathodendrahtes zu einem Gettermetall-Legierungsplasma unter Aufrechterhaltung eines Metallplasmalichtbogens zwischen Kathodendraht und einem den Kathodendraht räumlich umgebenden käfigförmigen Anodenkörper die Innenwand des Hochvakuumbehälters plasmabeschichtet. Schließlich wird der beschichtete Ultrahochvakuum-Behälter nach dem Beschichten gasdicht bis zur Montage des Hochvakuumbehälters in einer Ultrahochvakuumanlage verschlossen.

Zum Zünden des Lichtbogens zwischen Kathodendraht und käfigförmiger Anode wird ein Hochspannungszündimpuls im Bereich von -18 kV bis -30 kV an die Zündelektrode auf dem Isolationskörper über eine Zündimpulszuführung angelegt. Dieser Zündimpuls reicht aus, um ein erstes Metallplasma zu initiieren, das sich dann zwischen Kathodendraht und käfigförmiger Anode ausbreitet.

In einem bevorzugten Durchführungsbeispiel des Verfahrens wird für die Aufrechterhaltung eines Gettermetall-Lichtbogens zwischen Kathodendraht und käfigförmigem Anodenkörper sowie der Innenwand des Hochvakuumbehälters der Anodenkörper und die Innenwand des Hochvakuumbehälters auf Massepotential gelegt und der Kathodendraht auf ein Kathodenpotential zwischen -100 V und -300 V gehalten. Diese im Verhältnis zum Zündimpuls niedrige Spannung reicht aus, um ein Gettermetall-Legierungsplasma bis zum Verbrauch des gesamten Kathodendrahts zu gewährleisten.

Ein weiteres bevorzugtes Durchführungsbeispiel des Verfahrens sieht vor, daß ein Metallplasmasprühkopf als Metallplasmagenerator, der einen Isolationskörper mit Kathodendrahtbündel und eine Zündelektrode und den umgebenden Anodenkörper umfaßt, nach dem Zünden des Gettermetall-Legierungsplasmas in dem Innenraum des zu beschichtenden Hochspannungsbehälters über eine lineare Hochspannungsschiebedurchführung linear verfahren wird. Dabei wird die Gettermetall-Legierung des Kathodendrahtbündels unter Plasmabildung auf der Innenwand des zu beschichtenden Hochspannungsbehälters abgeschieden. Durch das mechanische Verfahren des Sprühkopfes innerhalb des zu beschichtenden Hochvakuumbehälters ist die Länge des zu beschichtenden Hochvakuumbehälters nur durch die Länge der möglichen Lineardurchführung für die Versorgung des Metallplasmasprühkopfes begrenzt. Das hat den Vorteil, daß für verschiedene Längen von Hochvakuumbehälter immer der gleiche Metallplasmasprühkopf eingesetzt werden kann, solange die Länge des Behälters die Längen der Schiebedurchführung nicht überschreitet.

Auf eine derartige Schiebedurchführung kann verzichtet werden, wenn ein Metallplasmasprühstab, der der Länge des Hochvakuumbehälters angepaßt ist, eingesetzt wird. In dieser Ausführungsform des Verfahrens wird die Gettermetall-Legierung des auf einen Isolationsstab gewickelten Kathodendrahtes eines Metallplasmasprühstabes als Metallplasmagenerator von der Stirnseite des Metallplasmasprühstabes aus unter nacheinander ablaufender Metallplasmabildung der Kathodendrahtwindungen auf der Innenwand des zu beschichtenden Hochvakuumbehälters als Gettermetall-Beschichtung abgeschieden. Ein derartiges Verfahren hat den Vorteil, daß unmittelbar nach der Zündung durch einen Zündimpuls das Metallplasma solange aufrechterhalten wird, bis der Kathodendraht verbraucht ist oder das Kathodenpotential abgeschaltet ist.

Ein weiteres Durchführungsbeispiel des Verfahrens sieht vor, daß der Metallplasmagenerator während der Abscheidung der Gettermetall-Legierung über eine Hochvakuumdrehdurchführung gedreht wird. Bei diesem Verfahren der gleichzeitigen Drehung des Metallplasmagenerators, sei es in Form eines Metallplasmasprühkopfes oder in Form eines Metallplasmasprühstabes, wird gewährleistet, daß eine relativ gleichmäßig dicke Gettermetall-Legierungsschicht auf der Innenwand des Hochvakuumbehälters abgeschieden wird.

Ein weiteres bevorzugtes Durchführungsbeispiel des Verfahrens sieht vor, daß die Dicke der Beschichtung aus Gettermetall-Legierung unter Einsatz des Metallplasmasprühstabes durch die Dicke des Kathodendrahtes gesteuert wird. Durch einen dickeren Kathodendraht kann auch mehr auf der Innenwand des Behälters abgeschieden werden, so daß sich damit eine einfache, aber wirkungsvolle Vorausberechnung der Dicke der Gettermetall-Beschichtung für den Hochvakuumbehälter ergibt.

Während bei einem Metallplasmagenerator auf der Basis eines Metallplasmasprühstabes die Dicke des Kathodendrahtes entscheidend ist, wird die Dicke der Beschichtung mit Hilfe eines Metallplasmasprühkopfes durch die Geschwindigkeit bestimmt, mit der der Metallplasmasprühkopf in Längsrichtung durch den Hochvakuumbehälter verfahren wird. Bei einer langsamen, das heißt geringen Geschwindigkeit wird die Beschichtung dicker, bei einer höheren Geschwindigkeit vermindert sich die dicke der Beschichtung entsprechend. Das Bündel von Kathodendrähten im Zentrum des ringförmigen Isolationskörpers des Metallplasmasprühkopfes wird dazu kontinuierlich nachgeschoben, um ausreichend Gettermaterial nachzuliefern.

Eine bevorzugte Anwendung des Verfahrens wird für die Herstellung einer Gettermetall-Legierungsbeschichtung in einem Ionenstrahlführungsrohr vorgesehen. Derartige Ionenstrahlführungsrohre werden in Ionenstrahlbeschleunigungsanlagen eingesetzt und in die durch dieses Verfahren veredelten Innenwände der Ionenstrahlführungsrohre werden großflächige Getterpumpen geschaffen.Die Kosten für die Wartung, Reinigung und Evakuierung der Ionenstrahlbeschleunigungsanlage können damit reduziert werden.

Weitere Vorteile und Merkmale der vorliegenden Erfindung werden nun anhand von Ausführungsformen mit Bezug auf die beiliegenden Zeichnungen näher erläutert.
Figur 1 zeigt schematische Ansichten einer Anordnung für die Herstellung einer Gettermetall-Legierungsbeschichtung einer ersten Ausführungsform der Erfindung.
Figur 1a zeigt ein Schnittbild in der Schnittebene A-A der Figur 1b.
Figur 1b zeigt eine Prinzipskizze eines teilweise aufgebrochenen Hochvakuumbehälters mit einem Metallplasmasprühstab.
Figur 2 zeigt schematisch Ansichten einer Anordnung für die Herstellung der Gettermetall-Legierungsbeschichtung einer zweiten Ausführungsform der Erfindung.
Figur 2a zeigt ein Schnittbild in der Schnittebene entlang der Linie B-B der Figur 2b.
Figur 2b zeigt eine Prinzipskizze eines teilweise aufgebrochenen Hochvakuumbehälters mit einem Metallplasmasprühstab.
Figur 3 zeigt schematische Ansichten einer Anordnung für die Herstellung einer Gettermetall-Legierungsbeschichtung einer dritten Ausführungsform der Erfindung.
Figur 3a zeigt ein Schnittbild in der Schnittebene entlang der Linie C-C der Figur 3b.
Figur 3b zeigt eine Prinzipskizze eines teilweise aufgebrochenen Hochvakuumbehälters mit einem Metallsprühkopf.

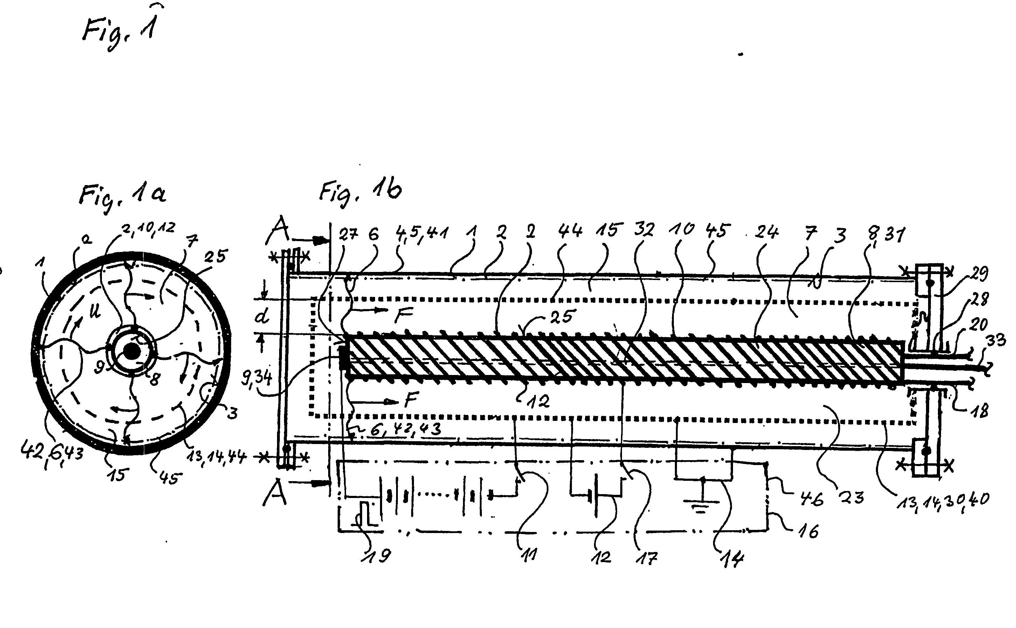

Figur 1 zeigt schematische Ansichten einer Anordnung für die Herstellung einer Gettermetall-Legierungsbeschichtung 1 einer ersten Ausführungsform der Erfindung. Die Figur 1a zeigt zunächst ein Schnittbild in der Schnittebene A-A der Figur 1b. Das Schnittbild in Figur 1a zeigt einen im Querschnitt kreisförmigen Hochvakuumbehälter 5, der durch Beschichtung seiner Innenwand 3 mit einer Gettermetall-Legierungsbeschichtung 1 zu einem Ultrahochvakuumbehälter 4 verbessert wird. Dazu ragt in den zylinderförmigen und im Querschnitt kreisrunden Hochvakuumbehälter 5 ein Isolationskörper 8, wie in Fig. 1b gezeigt, hinein, der als Stab ausgebildet ist und auf seinem Umfang vier gleichlaufende Wicklungen mit parallel verlaufenden Windungen eines Kathodendrahtes 10 aufweist. Die auf dem Mantel 25 angeordneten Kathodendrahtwicklungen weisen Gettermetall-Legierungen auf.

In dieser Ausführungsform besteht die Gettermetall-Legierung 2 aus drei Komponenten, nämlich Titan, Zirkonium und Vanadium, wobei Titan und Zirkonium hochwirksame Gettermetalle sind. Durch Veränderung der Volumenverhältnisse und der Art der Legierungskomponenten kann die Aktivierungstemperatur zwischen 120 °C und 500 °C eingestellt werden. Eine niedrige Aktivierungstemperatur zwischen 120 °C und 200 °C ist besonders vorteilhaft, wenn gleichzeitig mit einem Ausheizvorgang des Hochvakuumbehälters 5 auch die Reaktivierung der Oberfläche der Gettermetall-Legierungsbeschichtung erfolgen soll.

Wird eine Aktivierungstemperatur wesentlich über der Ausheiztemperatur angestrebt, um das Ausheizen zum Erreichen eines Hochvakuums von dem Reaktivieren der Gettermetallbeschichtung 1 zu trennen, um unabhängig von dem erfolgten Ausheizprozeß eine mehrfache Reaktivierung der Gettermetall-Legierungsbeschichtung 1 zu erreichen, so wird ein zusätzliches bei höchsten Temperaturen schmelzendes und verdampfendes Metall nämlich Hafnium eingesetzt, das eine Schmelztemperatur von 2.227 °C und eine Verdampfungstemperatur von 4.602 °C aufweist. Dazu wird das niedrigschmelzende Titan mit einer Schmelztemperatur von 1.660 °C ±10 °C und einer Verdampfungstemperatur von 3.287 °C durch das Hafnium ersetzt. Andererseits kann auch das hochschmelzende Vanadium durch Hafnium ersetzt werden, zumal Vanadium keine derart hohe Getterwirkung aufweist wie Hafnium. Mit einer Gettermetallbeschichtung, die als dritte Komponente Hafnium enthält, kann folglich ein verbessertes Ultrahochvakuum erreicht werden, da die Reaktivierung der Beschichtung 1 mehrfach bei erhöhter Temperatur zwischen 200 °C und 500 °C zur Erreichung eines Ultrahochvakuums durchführbar wird.

Der auf den Isolationsstab 8 gewickelte Kathodendraht 10 aus einer Gettermetall-Legierung 2 wird, um die Innenwand 3 des Hochvakuumbehälters 5 mit einer Gettermetall-Legierungsbeschichtung 1 zu versehen, auf der Stirnseite 27 des Metallplasmasprühstabes 23 gezündet und bei einer Vierfachwicklung, wie es in Figur 1a zu sehen ist, bilden sich vier Metallplasmaspuren 6 im Hochvakuum aus, die, wie in Figur 1a zu sehen ist, im Uhrzeigersinn in Pfeilrichtung U mit dem Aufbrauchen der Kathodendrahtwicklungen rotieren und dabei die Innenwand 3 des Hochvakuumbehälters 5 mit einer edelgasfreien Gettermetall-Beschichtung 1 aus einem reinen Gettermetall-Legierungsplasma 6 beschichten. Dazu ist die Kathode 10 auf dem Isolationskörper 8 in räumlichem Abstand d von einem käfigförmigen Anodenkörper 13 umgeben.

Der käfigförmige Anodenkörper 13 kann aus einem Drahtgitter 30 oder einem Lochblech 40 aufgebaut sein, wobei der Anodenkörper 13 und die Wand des Hochvakuumbehälters 5 auf ein Massepotential gelegt wird, während demgegenüber der Kathodendraht 10 bei einer Spannung von -100 bis -300 V gehalten wird. Diese Spannung wird über eine Hochvakuumdurchführung 18 dem Kathodendraht 10 zugeleitet. Mit einer derart niedrigen Spannungsdifferenz zwischen Anodenkörper 13 und Kathodendraht 10 kann jedoch kein Metallplasma gezündet werden. Dazu weist der Isolationskörper 8, der den Kathodendraht 10 auf seinem Mantel 25 trägt, wie es in Figur 1b zu sehen ist, einen zentralen Hochspannungszuführungsdraht 33 auf, der an der Stirnseite 27 des Isolationsstabes 24 mit einer kreisförmigen Metallplatte 34 als Zündelektrode 9 verbunden ist.

Beim Anlegen einer Hochspannung von mehr als 10 kV, die in dieser Ausführungsform der Erfindung mindestens 18 kV beträgt, bildet sich zunächst ein Plasma zwischen Zündelektrode 9 und Kathodendraht 10 an der Stirnseite 27 des Isolationskörpers 8 aus und sorgt für ein Zünden der Kathoden-Anoden-Strecke. Um einerseits keine Fremdmetalle in die Gettermetall-Beschichtung 1 einzubauen, sondern lediglich Gettermetalle aufzunehmen, kann die Zündelektrode 9 aus einem hochschmelzenden und bei hoher Temperatur verdampfenden Gettermetall aufgebaut sein. Das gleiche gilt für den käfigförmigen Anodenkörper 13, der ebenfalls aus einem hochschmelzenden und bei hoher Temperatur verdampfenden Gettermetalldraht oder Gettermetallblech hergestellt sein kann.

Nach dem Zünden der Kathodendrähte 10 auf der Stirnseite 27 des Metallplasmasprühstabes 23 wird unter einem sich drehenden Metallplasmalichtbogen 43 der Kathodendraht 10 verbraucht, wobei der sich drehende vierstrahlige Metallplasma-Lichtbogen 42 in Pfeilrichtung F auf die Hochvakuumdurchführung 18 verläuft und somit die Innenwand 3 auf der gesamten Länge des rohrförmigen Ho<chvakuumbehälters 4 beschichtet. Dabei bestimmt die Dicke der mit Hilfe des Metallplasmas aufgebrachten Gettermetall-Legierungsbeschichtung 1 der zur Verfügung stehende Gettermetalldraht der Kathode. Der Vorrat an Gettermetall kann durch den Drahtdurchmesser des Kathodendrahtes 10 variabel eingestellt werden. Der Vorgang des Verbrauchs des Kathodenmaterials läuft bei einem Lichtbogenverfahren, dem dieser Beschichtungsvorgang ähnlich ist, relativ schnell ab, so daß in kurzer Zeit der gesamte Hochvakuumbehälter 5 auf seiner Innenwand 3 mit einer Gettermetall-Legierung 2 in einer vorbestimmbaren Dicke beschichtet ist.

Figur 1b zeigt eine Prinzipskizze eines teilweise aufgebrochenen Hochvakuumbehälters 5 mit einem Metallplasmasprühstab 23 im Zentrum des Hochvakuumbehälters 4, der, wie oben erwähnt, rohrförmig ausgebildet ist. Dieser Metallplasmasprühstab 23 besteht im wesentlichen aus einem zylindrischen Isolationskörper 8, der auf seinem Zylindermantel 25, wie oben bereits geschildert, mehrere Wicklungen von Kathodendrähten 10 aufweist, die von der Stirnseite 27 des Isolationskörpers 8 aus über die Hochspannungszuführung 33 gezündet werden können, so daß sich von der Stirnseite 27 aus ein Metallplasmabogen ausbildet, der die gesamte Innenwand 3 des Hochvakuumbehälters 5 beschichtet. Die dabei entstehende Gettermetall-Legierungsbeschichtung 1 wird durch eine strichpunktierte Linie 44 in Figur 1b dargestellt, während der in räumlichem Abstand d zu dem Isolationskörper 8 angeordnete Anodenkörper 13 mit einer gestrichelten Linie 45 angedeutet wird. Diese gestrichelte Linie 45 soll gleichzeitig andeuten, daß der Anodenkörper 13 entweder aus einem Lochblech 40 oder aus einem Drahtgitter 30 bestehen kann.

Mit einer doppelpunktierten gestrichelten Linie 46 wird der Bereich einer Spannungsversorgungsvorrichtung 16 skizziert, die einerseits den Zündimpuls 19 an die Zündelektrode 9 liefern kann, und zwar über die Zuleitung 33,39, die in einer Vakuumhochspannungsdurchführung 20 geführt wird. Dazu wird ein Zündimpulsgeber 11 betätigt. Die Spannungsversorgungsvorrichtung 16 weist darüber hinaus eine Quelle für den Kathodenstrom auf, der mit einer Spannung zwischen -100 und -300 V über den Schalter 17 zwischen Anodenkörper, der auf Massepotential liegt, und Kathodendraht 10 geschaltet wird. Schließlich umfaßt die Spannungsversorgungsvorrichtung 16 eine Zuleitung für das Anodenpotential 14, das in dieser Ausführungsform der Erfindung zusammen mit dem Hochvakuumbehälter 5 auf ein Massepotential gelegt ist.

Der Metallplasmagenerator 7, der in dieser Ausführungsform im wesentlichen aus einem Metallplasmasprühstab 23 besteht und in den Hochvakuumbehälter 5 hineinragt, wird von einem Stützflansch 29, der einem entsprechenden Hochvakuumflansch des Hochvakuumbehälters 5 angepaßt ist, gehalten.

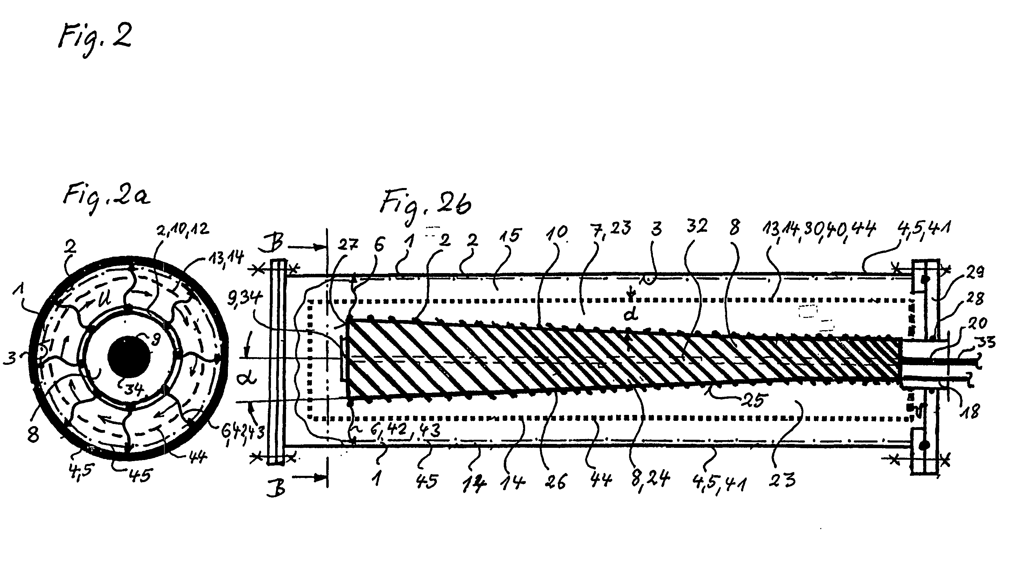

Figur 2 zeigt schematisch Ansichten einer Anordnung für die Herstellung einer Gettermetall-Beschichtung 1 einer zweiten Ausführungsform der Erfindung. Dabei zeigt die Figur 2a ein Schnittbild in der Schnittebene entlang der Linie B-B der Figur 2b, und die Figur 2b zeigt eine Prinzipskizze eines teilweise aufgebrochenen Hochvakuumbehälters 5 mit einem Metallplasmasprühstab 23. Komponenten mit gleichen Funktionen wie in den vorhergehenden Figuren werden mit gleichen Bezugszeichen gekennzeichnet und nicht extra erörtert.

Der wesentliche Unterschied zwischen der Ausführungsform nach Figur 1 und der Ausführungsform nach Figur 2 liegt darin, daß der Metallplasmasprühstab 23 in Figur 2b eine konische Form aufweist und zur Stirnseite 27 hin im Radius zunimmt. Dabei liegt der Konuswinkel zwischen 1° und 15°. Durch diese Konusform des Metallplasmasprühstabes 23 wird erreicht, daß einerseits das Metallplasma auf der Stirnseite 27, an der sich auch die Zündelektrode 9 in Form einer zentralen Metallplatte 34 befindet, beginnt und der räumliche Abstand d zwischen Anodenkörper 13 und Kathodendraht 10 zur Hochvakuumdurchführung 18 hin zunimmt, so daß der Verbrauch des Kathodendrahtes 10 definiert von der Stirnseite 27 zu den Hochvakuumführungen 18 und 20 durchläuft, ohne daß zwischendurch eine Unterbrechung des Kathodendrahtes 10 auftreten kann. Durch die konische Form wird demnach sichergestellt, daß ein nacheinander umwandeln Kathodendrahtmaterials im Metallplasma gewährleistet ist. Ein weiterer Unterschied zu der ersten Ausführungsform der Erfindung besteht darin, daß in diesem Fall anstelle von vier nun acht Kathodendrahtwicklungen parallel auf dem konisch zulaufenden Isolationsträger 8 angeordnet sind, was zur Vergleichmäßigung der Plasmawolke beiträgt.

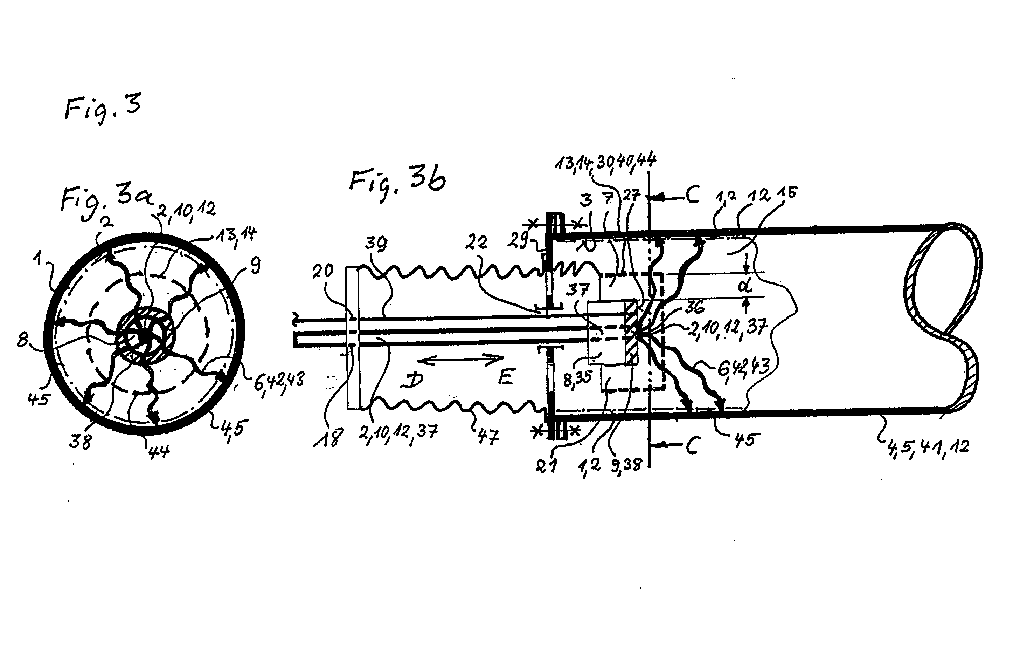

Figur 3 zeigt schematische Ansichten einer Anordnung für die Herstellung einer Gettermetall-Legierungsbeschichtung 1 einer dritten Ausführungsform der Erfindung. Dabei zeigt die Figur 3a ein Schnittbild in der Schnittebene entlang der Schnittlinie C-E der Figur 3b, und die Figur 3b zeigt eine Prinzipskizze eines teilweise aufgebrochenen Hochvakuumbehälters 5 mit einem Metallplasmasprühkopf 21. Komponenten mit gleichen Funktionen wie in den vorhergehenden Figuren werden mit gleichen Bezugszeichen gekennzeichnet und nicht extra erörtert.

Der wesentliche Unterschied zu den ersten beiden Ausführungsformen besteht darin, daß das Gettermetall-Legierungsplasma 6 mit einem Metallplasmasprühkopf 21 erzeugt wird und nicht mit einem Metallplasmasprühstab 23. Dieser Metallplasmasprühkopf 21 weist einen ringförmigen Isolationskörper 8 auf, auf dem als Zündelektrode ein Metallring 38 oder eine ringförmige Beschichtung angeordnet ist. Im Zentrum des Isolationskörpers 8 in Form eines Ringes, das heißt, in der Ringöffnung 36, weist der Metallplasmasprühkopf 21 ein Bündel 37 von Kathodendrähten 10 auf. Dieses Bündel 37 bildet beim Anleben eines Zündimpulses 19 an die ringförmige Zündelektrode 9 ein Plasma aus, das in Richtung auf den räumlich umgebenden Anodenkörper 13 sich ausbreitet und durch den käfigförmigen Anodenkörper 13 hindurch die Innenand 3 des Hochvakuumbehälters 5 mit einer Gettermetall-Legierungsbeschichtung 1 beschichtet.

Das Kathodendrahtbündel 10 kann in der Ringöffnung 36 ständig nachgeführt werden, so daß eine beliebig vergrößerbare Quelle von Gettermetall-Legierungen 2 zur Verfügung steht. Darüber hinaus weist die Anordnung eine Schiebedurchführung 22 auf, mit der in den Pfeilrichtungen D und E der Sprühkopf 21 linear verschoben werden kann. Dazu ist ein hochvakuumdichter Faltenbalg 47 mit einem entsprechenden Stützflansch 29 an einer Stirnseite 27 des Hochvakuumbehälters 5 hochvakuumdicht angeflanscht. Der Stützflansch 29 weist eine Schiebedurchführung 22 auf, so daß der Metallplasmasprühkopf 21 in Achsrichtung des Hochvakuumbehälters 5 linear verschoben werden kann und damit eine gleichmäßige Beschichtung 1 der Innenwand 3 mit einer Gettermetall-Legierungsbeschichtung 1 erreicht werden kann.

Die Dicke der Beschichtung 1 hängt nicht von dem Vorrat an Kathodendrahtmaterial in der Ringöffnung 36 ab, sondern lediglich von der Verfahrgeschwindigkeit, mit welcher der Sprühkopf 21 durch den Hochvakuumbehälter 5 gefahren wird. Somit sind mit dieser Anordnung beliebig dicke Gettermetall-Beschichtungen 1 möglich. Sowohl die erste als auch die zweite und die dritte Ausführungsform der Erfindung, wie sie in den Figuren 1 bis 3 gezeigt werden, können eine Drehdurchführung in dem Stützflansch 29 aufweisen, so daß die Metallplasmasprühstäbe 23 bzw. der Metallplasmasprühkopf 21 gedreht werden kann, um eine gleichmäßige Schichtdicke für die Gettermetall-Legierung 2 auf der Innenwand 3 des Hochvakuumbehälters 5 zu erreichen. Durch die Drehung des gesamten Plasmagenerators 7 wird nicht der käfigförmige Anodekörper auf der Innenwand 3 des Hochvakuumbehälters 5 abgebildet, was eventuell zu Unterschieden in der Schichtdicke führen kann.

In einzelnen Anwendungsfällen ist eine Variation der Schichtdicke als Abbild des käfigförmigen Anodenkörpers erwünscht, um die reaktive Oberfläche der Gettermetall-Legierungsbeschichtung 1 zu vergrößern. Jedoch sind dann für die Lebensdauer oder Gebrauchsdauer der Gettermetall-Beschichtung 1 die Bereiche entscheidend, welche die dünnste Gettermetallbeschichtung 1 aufweisen.

Mit allen drei Ausführungsformen der erfindungsgemäßen Anordnung zur Herstellung einer Gettermetall-Legierungsbeschichtung können die oben erwähnten Verfahren zur Herstellung einer Gettermetall-Beschichtung erfolgreich und ohne Einschluß von Edelgasen in die Gettermetall-Legierungsbeschichtung durchgeführt werden. Die Verfahrensdauer ist gegenüber herkömmlichen Verfahren, die mit einem Edelgassputtern arbeiten, wesentlich verkürzt, da keine hochschmelzenden Metalle durch Edelgasionen zerstäubt werden müssen. Auch die Schichtdicke der Gettermetall-Legierung ist durch das erfindungsgemäße Verfahren mit diesen in den Figuren 1 bis 3 gezeigten Ausführungsformen einer Anordnung zur Herstellung derartiger Gettermetall-Legierungsbeschichten 1 beliebig dick in vertretbarer Verfahrenszeit realisierbar.

Im Prinzip wird mit dem Verfahren und der Vorrichtung eine großflächige Gettermetallpumpe geschaffen, für die die gesamte Innenwand 3 eines Hochvakuumbehälters 5 zur Verfügung steht. Dieses ist besonders interessant für Ultrahochvakuumbehälter 4 zur Führung von Ionenstrahlen in einem Cyclotron oder in einem Linearbeschleuniger bzw. in einem Transportkanal für hochenergetische Ionen. Muß eine Gettermetall-Legierungsbeschichtung 1 erneuert werden, so kann die verbrauchte Gettermetall-Legierungsbeschichtung durch umgekehrte Polung in einem Elektropolierprozeß abgetragen werden, wobei die dafür erforderlichen Anordnungen den in den Figuren 1 bis 3 gezeigten Anordnungen ähneln. Nach dem Elektropolieren der Innenwände 3 der Behälter 5 kann dann erneut mit geringem Aufwand und Anflanschen von entsprechenden Metallplasmageneratoren 7 an den zu beschichtenden Hochvakuumbehälter 5 eine neue Ultrahochvakuum stützende Gettermetall-Legierungsbeschichtung 1 aufgebracht werden.

### Bezugszeichenliste

- 1: Beschichtung
- 2: Gettermetall-Legierung
- 3: Innenwand
- 4: Ultrahochvakuumbehälter
- 5: zu beschichtender Hochvakuumbehälter
- 6: Gettermetall-Legierungsplasma
- 7: Metallplasmagenerator
- 8: Isolationskörper
- 9: Zündelektrode
- 10: Kathodendraht
- 11: Zündimpulsgeber
- 12: Kathodenpotential
- 13: Anodenkörper
- 14: Anodenpotential
- 15: Innenraum
- 16: Spannungsversorgungsvorrichtung
- 17: Kathodenpotentialschalteinrichtung
- 18: Hochvakuumdurchführung
- 19: Hochspannungszündimpuls
- 20: Vakuumhochspannungsdurchführung
- 21: Metallplasmasprühkopf
- 22: Schiebedurchführung
- 23: Metallplasmasprühstab
- 24: Isolationsstab
- 25: Mantel des Isolationsstabes
- 26: Konus des Isolationsstabes
- 27: Stirnseite
- 28: Hochvakuumdrehdurchführung
- 29: Stützflansch
- 30: Drahtgitter
- 31: zylindrisches Keramikrohr
- 32: Achsbereich
- 33: Zuführungsdraht
- 34: zentrale Metallplatte (Zündelektrode)
- 35: Keramikring
- 36: Ringöffnung
- 37: Kathodendrahtbündel
- 38: Metallring
- 39: Zündleitung des Sprühkopfes
- 40: Lochblech
- 41: Ionenstrahlführungsrohr
- 42: Lichtbogen
- 43: Metallplasmalichtbogen
- 44: gestrichelte Linie
- 45: Strichpunktlinie
- 46: doppelpunktierte gestrichelte Linie
- 47: Faltenbalg
- A-A: Schnittlinien in den entsprechenden Figuren
- B-B: 1b, 2b und 3b
- C-C D, E: lineare Verfahrrichtungen
- d: räumlicher Abstand zwischen Anodenkörper und Isolationskörper
- α: Konuswinkel

## Patentansprüche

1. Beschichtung aus einer nichtverdampfenden Gettermetall-Legierung (2) für eine Innenwand (3) eines Ultrahochvakuum-Behälters (4), wobei die Gettermetall-Legierung (2) mindestens ein Gettermetall mit einer Schmelztemperatur über 1.500 °C und einer Verdampfungstemperatur über 3.000 °C aufweist,
**dadurch gekennzeichnet,**
**daß** die Gettermetall-Legierungsbeschichtung (1) von Edelgaseinschlüssen unbelastet ist und ein Metall-Legierungsabscheidungsprodukt eines edelgasfreien Gettermetall-Legierungsplasmas (6) aufweist.

2. Beschichtung nach Anspruch 1, **dadurch gekennzeichnet, daß** die Gettermetall-Legierung (2) Titan, Zirkonium und/oder Vanadium aufweist.

3. Beschichtung nach Anspruch 1, **dadurch gekennzeichnet, daß** die Gettermetall-Legierung (2) Titan, Zirkonium und/oder Hafnium aufweist.

4. Beschichtung nach Anspruch 1, **dadurch gekennzeichnet, daß** die Gettermetall-Legierung (2) Vanadium, Zirkonium und/oder Hafnium aufweist.

5. Beschichtung nach einem der Ansprüche 1 bis 4, **dadurch gekennzeichnet, daß** die Gettermetall-Legierung (2) eine Aktivierungstemperatur zwischen 120 °C und 500 °C aufweist.

6. Beschichtung nach einem der Ansprüche 1 bis 4, **dadurch gekennzeichnet,daß** die Gettermetall-Legierung (2) eine Aktivieringstemperatur unter 200°C und über 120°C aufweist.

7. Beschichtung nach einem der Ansprüche 1 bis 4, **dadurch gekennzeichnet, daß** die Gettermetall-Legierung (2) eine Aktivieringstemperatur unter 250°C und über 500°C aufweist.

8. Anordnung für die Herstellung einer Gettermetall-Legierungsbeschichtung (1) auf einer Innenwand (3) eines zu beschichtenden Hochvakummbehälters (5) nach einem der vorhergehenden Ansprüche,
**dadurch gekennzeichnet,**
**daß** die Anordnung einen Metallplasmagenerator (7) aufweist, der folgende Kompomenten aufweist:
- einen Isolationskörper (8) mit einer Zündelektrode (9) und einem Kathodendraht (10) aus einer Gettermetall-Legierung (2), wobei Zündelektrode (9) und Kathodendraht (10) mit einem Zündimplusgeber (11) bzw. mit einem Kathodenpotential (12) verbindbar sind und an dem Isolationskörper (8) raümlich getrennt voneinander angeordnet sind,
- einen käfigförmigen Anordenkörper (13), der den Isolationskörper (8) in einem raümlichen Abstand (d) umgibt und mit einem Anodenpotantial (14) verbindbar ist, wobei Isolationkörper (8) und umgebender Anodenkörper (13) in den Innenraum (15) des zu beschichtenden Hochvakuumbehälters (5) beim Beschichten hineinragen,
- eine Spannungsversorgunsvorrichtung (16) mit Kathodenpotential-Schalteinrichtung (17) für ein Anlegen des Kathodenpotentials (12) über eine Vakuumdurchfürhrung (18) an den Kathodendraht (10) und zum Anlegen eines Hochspannungzündimpulses (19) über eine Vakuumspannung-durchführung (20) an die Zündelektrode (9) sowie zum Anschluß des Anodenpotentials (14) an den zu beschichtenden Hochvakuumbehälter (5) und den Anodenkörper (13).

9. Anordnung nach Anspruch 8, **dadurch gekennzeichnet, daß** die Anordnung einen Metallplasmasprühkopf (21) aufweist, der den Isolationskörper (8) mit Kathodendraht (10) und Zündelektrode (9) und den umgebenden Anodenkörper (13) umfaßt und in dem Innenraum (15) des zu beschichtenden Hochvakuumbehälters (5) unter Hochvakuum verfahrbar angeordnet ist.

10. Anordnung nach Anspruch 9, **dadurch gekennzeichnet, daß** die Anordnung eine Hochvakuumschiebedurchführung (22) aufweist, die eine Linearverschiebung des Metallplasmasprühkopfes (21) innerhalb des Innenraums (15) des zu beschichtenden Hochvakuumbehälters (5) ermöglicht.

11. Anordnung nach Anspruch 8, **dadurch gekennzeichnet, daß** die Anordnung einen Metallplasmasprühstab (23) aufweist, der einen Isolationsstab (24) als Isolationskörper (8) mit Zündelektrode (9) und auf seinem Mantel (25) einen aufgewickelten Kathodendraht (10) sowie den umgebenden Anodenkörper (13) umfaßt und in dem Innenraum (15) des zu beschichtenden Hochvakuumbehälters (5) angeordnet ist.

12. Anordnung nach Anspruch 11, **dadurch gekennzeichnet, daß** der Isolationsstab (24) in axialer Richtung einen Konus (26) aufweist, dessen Radius in axialer Richtung zu der Stirnseite (27) des Isolationsstabes (24) hin zunimmt.

13. Anordnung nach Anspruch 12, **dadurch gekennzeichnet, daß** der Isolationsstab (24) einen Konuswinkel (α) zwischen 1° und 15° aufweist.

14. Anordnung nach einem der Ansprüche 9 bis 13, **dadurch gekennzeichnet, daß** die Anordnung eine Drehdurchführung (28) für den Metallplasmasprühstab (23) und/oder den Metallplasmasprühkopf (21) aufweist.

15. Anordnung nach einem der Ansprüche 9 bis 14, **dadurch gekennzeichnet, daß** sie Anordnung einen Stützflansch (29) aufweist, der den Metallplasmasprühstab (23) und/oder den Metallplasmasprühkopf (21) trägt, und an den zu beschichtenden Hochvakuumbehälter (5) hochvakuumdicht anflanschbar ist.

16. Anordnung nach einem der Ansprüche 8 bis 15, **dadurch gekennzeichnet, daß** der käfigförmige Anodenkörper (13) aus einem Drahtgitter (30) gebildet ist.

17. Anordnung nach einem der Ansprüche 8 bis 15, **dadurch gekennzeichnet, daß** der käfigförmige Anodenkörper (13) aus einem Lochblech gebildet ist.

18. Anordnung nach einem der Ansprüche 8 bis 17, **dadurch gekennzeichnet, daß** der Anodenkörper (13) eine hochschmelzende Metall-Legierung mit einer Schmelztemperatur über 1.500 °C und mit einer Verdampfungstemperatur über 3.000 °C aufweist.

19. Anordnung nach einem der Ansprüche 8 bis 18, **dadurch gekennzeichnet, daß** der Anodenkörper (13) eine Gettermetall-Legierung (2) aufweist, die eine höhere Verdampfungstemperatur aufweist als der Kathodendraht.

20. Anordnung nach einem der Ansprüche 8 bis 19, **dadurch gekennzeichnet, daß** die Zündelektrode (9) an der in den Hochvakuumbehälter (5) hineinragenden Stirnseite (27) des Isolationskörpers (8) angeordnet ist.

21. Anordnung nach einem der Ansprüche 8 bis 20, **dadurch gekennzeichnet, daß** der Isolationskörper (8) ein zylindrisches Keramikrohr (31) aufweist, das in seinem Achsbereich (32) einen Zuführungsdraht (33) zu einer zentralen Metallplatte (34) als Zündelektrode (9) auf der Stirnseite (27) des Isolationskörpers (8) aufweist.

22. Anordnung nach einem der Ansprüche 8 bis 20, **dadurch gekennzeichnet, daß** der Isolationskörper (8) einen Keramikring (35) aufweist, dessen Ringöffnung (36) ein Bündel (37) aus Kathodendrähten (10) aufweist und der als Zündelektrode (9) einen Metallring (38) trägt, welcher über eine Zündzuleitung (39) mit der Spannungsversorgungsvorrichtung (16) in Wirkverbindung steht.

23. Anordnung nach einem der Ansprüche 8 bis 22, **dadurch gekennzeichnet, daß** die Zündelektrode (9) eine hochschmelzende Metall-Legierung mit einer Schmelztemperatur über 1.500 °C und mit einer Verdampfungstemperatur über 3.000 °C aufweist.

24. Anordnung nach einem der Ansprüche 8 bis 23, **dadurch gekennzeichnet, daß** die Zündelektrode (9) eine Gettermetall-Legierung aufweist, die eine höhere Verdampfungstemperatur aufweist als der Kathodendraht (10).

25. Anordnung nach einem der Ansprüche 8 bis 24, **dadurch gekennzeichnet, daß** der zu beschichtende Hochvakuumbehälter (5) ein Strahlführungsrohr (41) einer Ionenstrahlbeschleunigungsanlage ist.

26. Verfahren zur Herstellung einer Beschichtung (1) aus einer nichtverdampfenden Gettermetall-Legierung (2) auf einer Innenwand (3) eines zu beschichtenden Hochvakuumbehälters, wobei die Gettermetall-Legierung (2) mindestens ein Gettermetall mit einer Schmelztemperatur über 1.500 °C und einer Verdampfungs-temperatur über 3.000 °C aufweist und das Verfahren folgende Verfahrensschritte aufweist:
- Zünden eines Lichtbogens (42) zwischen einem Kathodendraht (10) aus einer Gettermetall-Legierung (2) und einem Anodenkörper (13) mittels mindestens eines Hochspannungszündimpulses (19),
- fortlaufendes Umwandeln des Kathodendrahtes (10) zu einem Gettermetall-Legierungsplasma unter Aufrechterhaltung eines Metallplasmalichtbogens (43) zwischen Kathodendraht (10) und einem den Kathodendraht (10) räumlich umgebenden käfigförmigen Anodenkörper (13),
- Plasmabeschichten der Innenwand (3) des zu beschichtenden Hochvakuumbehälters (5) unter Hochvakuum,
- gasdichtes Verschließen des beschichteten Ultrahochvakuum-Behälters (4) nach dem Beschichten.

27. Verfahren nach Anspruch 26, **dadurch gekennzeichnet, daß** für das Zünden des Lichtbogens (42) ein Hochspannungszündimpuls (19) im Bereich von minus 18 kV bis minus 30 kV an eine Zündelektrode (9) auf einem Isolationskörper (8) über eine Zündimpulszuführung (33, 39) angelegt wird.

28. Verfahren nach Anspruch 26 oder Anspruch 27, **dadurch gekennzeichnet, daß** für die Aufrechterhaltung eines Gettermetall-Lichtbogens (42) zwischen Kathodendraht (10) und Anodenkörper (13) sowie Innenwand (3) des zu beschichtenden Hochvakuumbehälters (5) der Anodenkörper (13) und die Innenwand (3) des zu beschichtenden Hochvakuumbehälters (5) auf Massepotential (14) und der Kathodendraht (10) auf ein Kathodenpotential (12) zwischen -100 V und -300 V gelegt wird.

29. Verfahren nach einem der Ansprüche 26 bis 28, **dadurch gekennzeichnet, daß** ein Metallplasmasprühkopf (21) als Metallplasmagenerator (7), der einen Isolationskörper (8) mit Kathodendrahtbündel (37) und Zündelektrode (9) und den umgebenden Anodenkörper (13) umfaßt, nach dem Zünden des Gettermetall-Legierungsplasmas (6) in dem Innenraum (15) des zu beschichtenden Hochvakuumbehälters (5) über eine lineare Hochvakuumschichtdurchführung (22) linear verfahren wird, wobei die Gettermetall-Legierung (2) des Kathodendrahtbündels (37) unter Plasmabildung auf der Innenwand (3) des zu beschichtenden Hochvakuumbehälters (5) abgeschieden wird.

30. Verfahren nach einem der Ansprüche 26 bis 29, **dadurch gekennzeichnet, daß** die Gettermetall-Legierung des auf einen Isolationsstab (24) gewickelten Kathodendrahtes (10) eines Metallplasmasprühstabes (23) als Metallplasmagenerator (7) von der Stirnseite (27) des Metallplasmasprühstabes (24) aus unter nacheinander ablaufender Metallplasmabildung der Kathodendrahtwindungen auf der Innenwand (3) des zu beschichtenden Hochvakuumbehälters (5) als Beschichtung (1) abgeschieden wird.

31. Verfahren nach einem der Ansprüche 26 bis 30, **dadurch gekennzeichnet, daß** der Metallplasmagenerator (7) während der Abscheidung der Gettermetall-Legierung (2) über eine Hochvakuum-Drehdurchführung (28) gedreht wird.

32. Verfahren nach einem der Ansprüche 26 bis 31, **dadurch gekennzeichnet, daß** die Dicke der Beschichtung (1) aus Gettermetall-Legierung (2) unter Einsatz des Metallplasmasprühstabes (24) durch die Dicke des Kathodendrahtes (10) gesteuert wird.

33. Verfahren nach einem der Ansprüche 26 bis 31, **dadurch gekennzeichnet, daß** die Dicke der Beschichtung (1) aus Gettermetall-Legierung (2) unter Einsatz des Metallplasmasprühkopfes (21) durch die Verfahrgeschwindigkeit des Metallplasmasprühkopfs (21) in Achsrichtung des zu beschichtenden Hochvakuumbehälters (5) gesteuert wird.

34. Verfahren nach einem der Ansprüche 26 bis 33, **dadurch gekennzeichnet, daß** ein Ionenstrahlführungsrohr (41) einer Ionenstrahlbeschleunigungsanlage mit der Gettermetall-Legierung (2) beschichtet wird, um ein Ultrahochvakuum in dem Ionenstrahlführungsrohr (41) zu ermöglichen.

## Claims

1. Coating comprising a non-vaporising getter metal alloy (2) for an inner wall (3) of an ultra-high-vacuum vessel (4), the getter metal alloy (2) comprising at least one getter metal having a melting point above 1,500°C and a vaporisation temperature above 3,000°C,
**characterised in that**
the getter metal alloy coating (1) is not encumbered with noble gas inclusions and comprises a metal alloy deposition product from a noble-gas-free getter metal alloy plasma (6).

2. Coating according to claim 1, **characterised in that** the getter metal alloy (2) comprises titanium, zirconium and/or vanadium.

3. Coating according to claim 1, **characterised in that** the getter metal alloy (2) comprises titanium, zirconium and/or hafnium.

4. Coating according to claim 1, **characterised in that** the getter metal alloy (2) comprises vanadium, zirconium and/or hafnium.

5. Coating according to one of claims 1 to 4, **characterised in that** the getter metal alloy (2) has an activation temperature between 120°C and 500°C.

6. Coating according to one of claims 1 to 4, **characterised in that** the getter metal alloy (2) has an activation temperature below 200°C and above 120°C.

7. Coating according to one of claims 1 to 4, **characterised in that** the getter metal alloy (2) has an activation temperature above 250°C and up to 500°C.

8. Arrangement for the production of a getter metal alloy coating (1) on an inner wall (3) of a high-vacuum vessel (5) to be coated, according to one of the preceding claims,
**characterised in that**
the arrangement comprises a metal plasma generator (7), which comprises the following components:
- an insulator member (8) having an ignition electrode (9) and having a cathode wire (10) comprising a getter metal alloy (2), the ignition electrode (9) and cathode wire (10) being connectible to an ignition pulse generator (11) and to a cathode potential (12), respectively, and being arranged on the insulator member (8) spatially separated from one another,
- a cage-shaped anode member (13), which surrounds the insulator member (8), spatially spaced (d) apart therefrom, and which is connectible to an anode potential (14), the insulator member (8) and the surrounding anode member (13) projecting, during coating, into the interior (15) of the high-vacuum vessel (5) to be coated,
- a voltage supply apparatus (16) having a cathode potential switching device (17) for application of the cathode potential (12) by way of a vacuum port (18) to the cathode wire (10) and for the application of a high-voltage ignition pulse (19) by way of a vacuum high-voltage port (20) to the ignition electrode (9) and for the connection of the anode potential (14) to the high-vacuum vessel (5) to be coated and to the anode member (13).

9. Arrangement according to claim 8, **characterised in that** the arrangement comprises a metal plasma spray head (21), which comprises the insulator member (8) having the cathode wire (10) and ignition electrode (9) and the surrounding anode member (13) and which is arranged to be movable under a high vacuum within the interior (15) of the high-vacuum vessel (5) to be coated.

10. Arrangement according to claim 9, **characterised in that** the arrangement comprises a high-vacuum slide-through port (22), which makes possible linear displacement of the metal plasma spray head (21) within the interior (15) of the high-vacuum vessel (5) to be coated.

11. Arrangement according to claim 8, **characterised in that** the arrangement comprises a metal plasma spray rod (23), which comprises an insulator rod (24) as insulator member (8) having an ignition electrode (9) and, on its envelope surface (25), a wound-on cathode wire (10) and also the surrounding anode member (13) and which is arranged in the interior (15) of the high-vacuum vessel (5) to be coated.

12. Arrangement according to claim 11, **characterised in that** the insulator rod (24) has a cone (26) in the axial direction, the radius of which increases in the axial direction towards the end face (27) of the insulator rod (24).

13. Arrangement according to claim 12, **characterised in that** the insulator rod (24) has a cone angle (α) between 1° and 15°.

14. Arrangement according to one of claims 9 to 13, **characterised in that** the arrangement comprises a rotary port (28) for the metal plasma spray rod (23) and/or the metal plasma spray head (21).

15. Arrangement according to one of claims 9 to 14, **characterised in that** the arrangement comprises a supporting flange (29), which carries the metal plasma spray rod (23) and/or the metal plasma spray head (21) and which is arranged to be flange-mounted in high-vacuum-tight manner on the high-vacuum vessel (5) to be coated.

16. Arrangement according to one of claims 8 to 15, **characterised in that** the cage-shaped anode member (13) is formed by a wire grating (30).

17. Arrangement according to one of claims 8 to 15, **characterised in that** the cage-shaped anode member (13) is formed by a perforated plate.

18. Arrangement according to one of claims 8 to 17, **characterised in that** the anode member (13) comprises a high-melting metal alloy having a melting point above 1,500°C and a vaporisation temperature above 3,000°C.

19. Arrangement according to one of claims 8 to 18, **characterised in that** the anode member (13) comprises a getter metal alloy (2) which has a higher vaporisation temperature than the cathode wire.

20. Arrangement according to one of claims 8 to 19, **characterised in that** the ignition electrode (9) is arranged at that end face (27) of the insulator member (8) which projects into the high-vacuum vessel (5).

21. Arrangement according to one of claims 8 to 20, **characterised in that** the insulator member (8) comprises a cylindrical ceramic tube (31) comprising, in its axial region (32), a supply wire (33) to a central metal plate (34) as ignition electrode (9) at the end face (27) of the insulator member (8).

22. Arrangement according to one of claims 8 to 20, **characterised in that** the insulator member (8) comprises a ceramic ring (35), the ring opening (36) of which comprises a bundle (37) of cathode wires (10) and which carries a metal ring (38) as ignition electrode (9), which is in operative connection with the voltage supply apparatus (16) by way of an ignition supply line (39).

23. Arrangement according to one of claims 8 to 22, **characterised in that** the ignition electrode (9) comprises a high-melting metal alloy having a melting point above 1,500°C and a vaporisation temperature above 3,000°C.

24. Arrangement according to one of claims 8 to 23, **characterised in that** the ignition electrode (9) comprises a getter metal alloy (2) which has a higher vaporisation temperature than the cathode wire (10).

25. Arrangement according to one of claims 8 to 24, **characterised in that** the high-vacuum vessel (5) to be coated is a beam guidance tube (41) of an ion beam acceleration system.

26. Method for the production of a coating (1) comprising a non-vaporising getter metal alloy (2) on an inner wall (3) of a high-vacuum vessel to be coated, the getter metal alloy (2) comprising at least one getter metal having a melting point above 1,500°C and a vaporisation temperature above 3,000°C, and the method comprising the following method steps:
- ignition of a light arc (42) between a cathode wire (10) comprising a getter metal alloy (2) and an anode member (13) by means of at least a high-voltage ignition pulse (19),
- continuing conversion of the cathode wire (10) into a getter metal alloy plasma while maintaining a metal plasma light arc (43) between the cathode wire (10) and a cage-shaped anode member (13) spatially surrounding the cathode wire (10),
- plasma coating, under a high vacuum, of the inner wall (3) of the high-vacuum vessel (5) to be coated,
- gas-tight closure of the coated ultra-high-vacuum vessel (4) after coating.

27. Method according to claim 26, **characterised in that,** for ignition of the light arc (42), a high-voltage ignition pulse (19) in the range from minus 18 kV to minus 30 kV is applied to an ignition electrode (9) on an insulator member (8) by way of an ignition pulse supply (33, 39).

28. Method according to claim 26 or claim 27, **characterised in that**, for the maintenance of a getter metal light arc (42) between the cathode wire (10) and anode member (13) and the inner wall (3) of the high-vacuum vessel (5) to be coated, the anode member (13) and the inner wall (3) of the high-vacuum vessel (5) to be coated are held at ground potential (14) and the cathode wire (10) is held at a cathode potential (12) between -100 V and -300 V.

29. Method according to one of claims 26 to 28, **characterised in that** a metal plasma spray head (21) as metal plasma generator (7), which comprises an insulator member (8) having a cathode wire bundle (37) and ignition electrode (9) and the surrounding anode member (13), is, after ignition of the getter metal alloy plasma (6), moved linearly, by means of a linear high-vacuum layer port (22), within the interior (15) of the high-vacuum vessel (5) to be coated, the getter metal alloy (2) of the cathode wire bundle (37) being deposited, with plasma formation, on the inner wall (3) of the high-vacuum vessel (5) to be coated.

30. Method according to one of claims 26 to 29, **characterised in that** the getter metal alloy of the cathode wire (10), wound onto an insulator rod (24), of a metal plasma spray rod (23) as metal plasma generator (7) is deposited as a coating (1) on the inner wall (3) of the high-vacuum vessel (5) to be coated, starting from the end face (27) of the metal plasma spray rod (24), with successively occurring metal plasma formation of the cathode wire windings.

31. Method according to one of claims 26 to 30, **characterised in that** the metal plasma generator (7) is rotated, during deposition of the getter metal alloy (2), by means of a high-vacuum rotary port (28).

32. Method according to one of claims 26 to 31, **characterised in that** the thickness of the coating (1) of getter metal alloy (2) is, when the metal plasma spray rod (24) is used, controlled by the thickness of the cathode wire (10).

33. Method according to one of claims 26 to 31, **characterised in that** the thickness of the coating (1) of getter metal alloy (2) is, when the metal plasma spray head (21) is used, controlled by the speed of movement of the metal plasma spray head (21) in the axial direction of the high-vacuum vessel (5) to be coated.

34. Method according to one of claims 26 to 33, **characterised in that** an ion beam guidance tube (41) of an ion beam acceleration system is coated with the getter metal alloy (2) in order to make possible an ultra-high vacuum in the ion beam guidance tube (41).

## Revendications

1. Revêtement à base d'un alliage de métal getter non vaporisable (2) pour la paroi interne (3) d'un récipient de haut vide (4), où l'alliage de métal getter (2) présente au moins un métal getter avec une température de fusion supérieure à 1500°C et une température de vaporisation supérieure à 3000°C, **caractérisé en ce que** le revêtement (1) d'alliage de métal getter n'est pas chargé d'inclusions de gaz noble et présente un produit de séparation d'un alliage métallique d'un plasma d'alliage de métal getter exempt de gaz noble (6).

2. Revêtement selon la revendication 1, **caractérisé en ce que** l'alliage de métal getter (2) présente du titane, du zirconium et/ou du vanadium.

3. Revêtement selon la revendication 1, **caractérisé en ce que** l'alliage de métal getter (2) présente du titane, du zirconium et/ou du hafnium.

4. Revêtement selon la revendication 1, **caractérisé en ce que** l'alliage de métal getter (2) présente du vanadium, du zirconium et/ou du hafnium.

5. Revêtement selon l'une quelconque des revendications 1 à 4, **caractérisé en ce que** l'alliage de métal getter (2) présente une température d'activation allant de 120°C à 500°C.

6. Revêtement selon l'une quelconque des revendications 1 à 4, **caractérisé en ce que** l'alliage de métal getter (2) présente une température d'activation inférieure à 200°C et supérieure à 120°C.

7. Revêtement selon l'une quelconque des revendications 1 à 4, **caractérisé en ce que** l'alliage de métal getter (2) présente une température d'activation supérieure à 250°C et jusqu'à 500°C.

8. Installation pour la préparation d'un revêtement (1) à base d'un alliage de métal getter sur la paroi interne (3) d'un récipient de haut vide (5) à revêtir selon l'une des revendications précédentes, **caractérisée en ce que** l'installation présente un générateur de plasma métallique (7), qui se compose des composants suivants :
- un corps isolant (8) avec une électrode d'amorçage (9) et un fil de cathode (10) en un alliage de métal getter (2),
où l'électrode d'amorçage (9) et le fil de cathode (10) peuvent être reliés à un donneur d'impulsion d'amorçage (11) ou à un potentiel de cathode (12) et sont disposés de manière spatialement séparée sur le corps isolant (8),
- un corps d'anode (13) en forme de cage, qui entoure le corps isolant (8) à une certaine distance (d) et peut être relié à un potentiel d'anode (14), où le corps isolant (8) et le corps d'anode entourant (13) sont introduits dans l'espace interne (15) du récipient de haut vide (5) à revêtir pendant le revêtement,
- un dispositif d'approvisionnement en tension (16) avec dispositif de commutation du potentiel de cathode (17) pour l'imposition du potentiel de cathode (12) par mise sous vide (18) sur le fil de cathode (10) et pour l'imposition d'une impulsion d'amorçage de tension élevée (19) par une mise sous tension de haut vide (20) sur l'électrode d'amorçage (9) ainsi que pour l'imposition du potentiel d'anode (14) sur le récipient de haut vide (5) à revêtir et le corps d'anode (13).

9. Installation selon la revendication 8, **caractérisée en ce que** l'installation présente une tête de projection de plasma métallique (21), qui comprend le corps isolant (8) avec le fil de cathode (10) et l'électrode d'amorçage (9) et le corps d'anode entourant (13), et est disposé de manière déplaçable, sous vide, dans l'espace interne (15) du récipient de haut vide (5) à revêtir.

10. Installation selon la revendication 9, **caractérisée en ce que** l'installation présente un passage à mouvement rectiligne de haut vide (22), qui permet un déplacement linéaire de la tête de projection de plasma métallique (21) dans l'espace interne (15) du récipient de haut vide (5) à revêtir.

11. Installation selon la revendication 8, **caractérisée en ce que** l'installation présente un bâtonnet de projection de plasma métallique (23), qui comprend un bâtonnet isolant (24) comme corps isolant (8) avec électrode d'amorçage (9) et sur son manteau (25), un fil de cathode (10) enroulé, ainsi que le corps d'anode (13) et est disposé dans l'espace interne (15) du récipient de haut vide (5) à revêtir.

12. Installation selon la revendication 11, **caractérisée en ce que** le bâtonnet isolant (24) présente en direction axiale, un cône (26), dont le rayon en direction axiale vers la face (27) du bâtonnet isolant (24) augmente.

13. Installation selon la revendication 12, **caractérisée en ce que** le bâtonnet isolant (24) présente un angle du cône (α) allant de 1° à 15°.

14. Installation selon l'une quelconque des revendications 9 à 13, **caractérisée en ce que** l'installation présente un passage tournant (28) pour le bâtonnet de projection de plasma métallique (23) et/ou la tête de projection de plasma métallique (21).

15. Installation selon l'une quelconque des revendications 9 à 14, **caractérisée en ce que** l'installation présente une bride support (29), qui porte le bâtonnet de projection de plasma métallique (23) et/ou la tête de projection de plasma métallique (21), et à laquelle le récipient de haut vide (5) à revêtir peut être bridé de manière étanche haut vide.

16. Installation selon l'une quelconque des revendications 8 à 15, **caractérisée en ce que** le corps d'anode en forme de cage (13) est formé comme un grillage (30).

17. Installation selon l'une quelconque des revendications 8 à 15, **caractérisée en ce que** le corps d'anode en forme de cage (13) est formé comme une tôle percée.

18. Installation selon l'une quelconque des revendications 8 à 17, **caractérisée en ce que** le corps d'anode (13) présente un alliage métallique à haut point de fusion, avec une température de fusion supérieure à 1500°C et avec une température de vaporisation supérieure à 3000°C.

19. Installation selon l'une quelconque des revendications 8 à 18, **caractérisée en ce que** le corps d'anode (13) présente un alliage de métal getter (2), qui présente une température élevée de vaporisation, comme fil de cathode.

20. Installation selon l'une quelconque des revendications 8 à 19, **caractérisée en ce que** l'électrode d'amorçage (9) est disposée sur la face (27) introduite dans le récipient de haut vide (5), du corps isolant (8).

21. Installation selon l'une quelconque des revendications 8 à 20, **caractérisée en ce que** le corps isolant (8) présente un tube cylindrique en céramique (31), qui présente au niveau de son axe (32), un fil d'alimentation (33) à une plaque métallique (34) centrale comme électrode d'amorçage (9) sur la face (27) du corps isolant (8).

22. Installation selon l'une quelconque des revendications 8 à 20, **caractérisée en ce que** le corps isolant (8) présente un anneau en céramique (35), dont l'ouverture annulaire (36) présente un faisceau (37) de fils de cathode (10) et qui porte comme électrode d'amorçage (9), un anneau métallique (38), qui est en connexion avec le dispositif d'approvisionnement de tension (16) par une conduite d'amorçage (39).

23. Installation selon l'une quelconque des revendications 8 à 22, **caractérisée en ce que** l'électrode d'amorçage (9) présente un alliage métallique de point de fusion élevé, avec une température de fusion supérieure à 1500°C et une température d'évaporation supérieure à 3000°C.

24. Installation selon l'une quelconque des revendications 8 à 23, **caractérisée en ce que** l'électrode d'amorçage (9) présente un alliage de métal getter, qui présente une température d'évaporation supérieure à celle du fil de cathode (10).

25. Installation selon l'une quelconque des revendications 8 à 24, **caractérisée en ce que** le récipient de haut vide (5) à revêtir est un tube de positionnement de faisceau (41) d'une installation d'accélération de faisceau ionique.

26. Procédé de préparation d'un revêtement (1) en un alliage de métal getter non vaporisable (2) sur la paroi interne (3) d'un récipient de haut vide à revêtir, où l'alliage de métal getter (2) présente au moins un métal getter avec une température de fusion supérieure à 1500°C et une température de vaporisation supérieure à 3000°C, et le procédé présente les étapes suivantes :
- allumage d'un arc électrique (42) entre un fil de cathode (10) en un alliage de métal getter (2) et un corps d'anode (13) à l'aide d'au moins une impulsion d'amorçage de haute tension (19),
- transformation continue du fil de cathode (10) en un plasma d'alliage de métal getter par maintien d'un arc électrique de plasma métallique (43) entre le fil de cathode (10) et un corps d'anode (13) en forme de cage, entourant un des fils de cathode (10),
- revêtement par plasma de la paroi interne (3) du récipient de haut vide (5) à revêtir, sous haut vide,
- fermeture étanche aux gaz du récipient de ultra-haut vide (4) après le revêtement.

27. Procédé selon la revendication 26, **caractérisé en ce que** pour l'allumage de l'arc électrique (42), on impose une impulsion d'amorçage de haute tension (19) dans l'intervalle de -18 kV à -30 kV à une électrode d'amorçage (9) sur un corps isolant (8) par une alimentation d'impulsion d'amorçage (33, 39).

28. Procédé selon la revendication 26 ou 27, **caractérisé en ce que** pour le maintien d'un arc électrique de métal getter (42) entre le fil de cathode (10) et le corps d'anode (13) ainsi que la paroi interne (3) du récipient de haut vide (5) à revêtir, le corps d'anode (13) et la paroi interne (3) du récipient de haut vide (5) à revêtir sont soumis à un potentiel de masse (14) et le fil de cathode (10) à un potentiel de cathode (12) allant de -100 V à -300 V.

29. Procédé selon l'une quelconque des revendications 26 à 28, **caractérisé en ce qu'**une tête de projection de plasma métallique (21) procède de manière linéaire, comme générateur de plasma métallique (7), qui comprend un corps isolant (8) avec faisceau de fils de cathode (37) et électrode d'amorçage (9) et le corps d'anode entourant (13), après l'allumage du plasma d'alliage de métal getter (6) dans l'espace interne (15) du récipient de haut vide (5) à revêtir, par passage linéaire d'une couche de haut vide (22), où l'alliage de métal getter (2) du faisceau de fils de cathode (37) est déposé sur la paroi interne (3) du récipient de haut vide (5) à revêtir, avec formation de plasma.

30. Procédé selon l'une quelconque des revendications 26 à 29, **caractérisé en ce que** l'alliage de métal getter du fil de cathode (10) enroulé sur un bâtonnet isolant (24) d'un bâtonnet de projection de plasma métallique (23) comme générateur de plasma métallique (7) de la face (27) du bâtonnet de projection de plasma métallique (24) est déposé comme revêtement (1), depuis la formation de plasma métallique de l'enroulement de fils de cathode sur la paroi interne (3) du récipient de haut vide (5) à revêtir.

31. Procédé selon l'une quelconque des revendications 26 à 30, **caractérisé en ce que** le générateur de plasma métallique (7) est tourné pendant la séparation de l'alliage de métal getter (2) par un passage tournant à haut vide (28).

32. Procédé selon l'une quelconque des revendications 26 à 31, **caractérisé en ce que** l'épaisseur du revêtement (1) en alliage de métal getter (2) est réglée par mise en oeuvre du bâtonnet de projection du plasma métallique (24), par l'épaisseur du fil de cathode (10).

33. Procédé selon l'une quelconque des revendications 26 à 31, **caractérisé en ce que** l'épaisseur du revêtement (1) en alliage de métal getter (2) est réglée par mise en oeuvre de la tête de projection du plasma métallique (21), par la vitesse de procédé de la tête de projection du plasma métallique (21), en direction axiale du récipient de haut vide (5) à revêtir.

34. Procédé selon l'une quelconque des revendications 26 à 33, **caractérisé en ce qu'**un tube de conduit de faisceau ionique d'une installation d'accélération de faisceau ionique (41) est revêtu de l'alliage de métal getter (2), pour permettre un vide ultra-haut dans le tube de conduite de faisceau ionique (41).
